# FASCICULE DE BREVET EUROPEEN

(11) **EP 3 963 342 B1**
(45) Date de publication et mention de la délivrance du brevet: **08.11.2023**
(21) Numéro de dépôt: 20722330.6
(22) Date de dépôt: 30.04.2020
(51) Int. Cl.: G01R 3/00, G01R 15/18

(54) **PROCÉDÉ DE FABRICATION D'UN DISPOSITIF DE PROTECTION DE COURT-CIRCUIT, DISPOSITIF DE PROTECTION DE COURT-CIRCUIT ET MODULE DE PUISSANCE ASSOCIÉS**
VERFAHREN ZUR HERSTELLUNG EINER KURZSCHLUSSSCHUTZVORRICHTUNG, KURZSCHLUSSSCHUTZVORRICHTUNG UND LEISTUNGSMODUL
METHOD FOR MANUFACTURING A SHORT-CIRCUIT PROTECTION DEVICE, AND ASSOCIATED SHORT-CIRCUIT PROTECTION DEVICE AND POWER MODULE

(30) Priorité: 03.05.2019 FR 1904683
(43) Date de publication de la demande: 09.03.2022
(73) Titulaire: SAFRAN, 75015 Paris (FR)
(72) Inventeur: AZZOPARDI, Stéphane, Joseph, 77550 Moissy-Cramayel (FR); YOUSSEF, Toni, 77550 Moissy-Cramayel (FR); KHAZAKA, Rabih, 77550 Moissy-Cramayel (FR); MARTINEAU, Donatien, Henri, Edouard, 77550 Moissy-Cramayel (FR); LE, Thanh Long, 77550 Moissy-Cramayel (FR)
(74) Mandataire: Brevalex
(86) Numéro de dépôt international: PCT/EP2020/062155
(87) Numéro de publication internationale: WO 2020/225133

(56) Documents cités:
- WO-A1-2018/116679
- WO-A1-2018/189035
- FR-A1- 2 968 085
- JP-A- H10 247 718
- JP-A- 2005 175 156
- US-A1- 2008 079 418
- US-A1- 2012 223 697
- US-A1- 2014 167 733
- US-A1- 2015 015 244

## Description

### DOMAINE TECHNIQUE

La présente invention concerne un procédé de fabrication d'un dispositif de protection de court-circuit. L'invention concerne également un dispositif de protection de court-circuit et un module de puissance comprenant un tel dispositif de protection.

L'invention s'applique au domaine de l'électronique, en particulier au domaine de l'électronique de puissance.

### ÉTAT DE LA TECHNIQUE ANTÉRIEURE

Il est connu de mettre en oeuvre des circuits de conversion d'énergie électrique entre un premier réseau alternatif ou continu vers un deuxième réseau alternatif ou continu. De tels circuits sont, par exemple, courants dans le domaine de l'aéronautique, où ils sont employés pour convertir l'énergie électrique fournie par un réseau principal (par exemple 115 V AC, 230 V AC, ou encore 540 V DC) sous plusieurs formes, qu'elles soient alternatives ou continues. De façon classique, de tels circuits de conversion mettent en oeuvre des éléments de commutation tels que des transistors.

Il est également connu de surveiller l'occurrence de surintensités affectant les éléments de commutation de tels circuits de conversion, et ce afin de prévenir leur vieillissement prématuré, voire leur destruction.

Par exemple, dans le cas de circuits de conversion comportant des éléments de commutation du type transistors IGBT (de l'anglais « *Insulated Gate Bipolar Transistor* », ou transistor bipolaire à grille isolée), il est connu de mettre en oeuvre une méthode de protection dite « par mesure de désaturation ».

Toutefois, une telle méthode de protection ne convient pas aux circuits de conversion intégrant des éléments de commutation à semi-conducteur à grand gap, par exemple des transistors à effet de champ du type MOSFET SiC (de l'anglais « *Silicon Carbide Métal Oxide Semiconductor Field Effect* », ou transistor à effet de champ à structure métal-oxyde-semiconducteur au carbure de silicium). En effet, le transistor MOSFET SiC fonctionne dans une région linéaire où la tension aux bornes dudit transistor (Vds) change plus lentement que la tension aux bornes d'un transistor IGBT, même quand le courant drain source (Ids) augmente. Ainsi, une situation de surintensité peut être présente pendant plusieurs cycles de commutation avant qu'une variation mesurable de la tension Vds ne se produise pour permettre une détection rapide, ce qui peut être suffisant pour endommager le composant. En outre, la résistance à l'état passant et donc la tension à l'état passant d'un transistor MOSFET SiC dépendant davantage de la température que celle d'un transistor IGBT, il est généralement difficile de déterminer une tension de seuil à utiliser pour l'implémentation de la méthode de désaturation.

Pour détecter des surintensités affectant des éléments de commutation à semi-conducteur à grand gap, il a été proposé d'équiper les circuits de conversion intégrant ces derniers de capteurs de courant, tels que des résistances shunt ou des capteurs à effet Hall.

Néanmoins, de tels capteurs de courant ne donnent pas satisfaction.

En effet, de tels capteurs de courant présentent généralement une bande passante insuffisante, un encombrement excessif et une faculté médiocre à supporter les températures élevées régnant au voisinage des éléments de commutation décrits ci-dessus. De plus, recourir à de tels capteurs de courant revient à ajouter des éléments parasites susceptibles de perturber le fonctionnement nominal des éléments de commutation. WO 2018 189035 A1, JP 2005 175156 A, JP H 10247718 A divulguent des dispositifs semi-conducteurs avec des capteurs de courant Rogowski.

Un but de l'invention est donc de proposer un dispositif de protection de court-circuit qui présente une bande passante plus élevée, un encombrement moindre, une meilleure tenue en température, et qui perturbe moins le fonctionnement nominal des éléments de commutation que les dispositifs de protection de l'état de la technique.

### EXPOSÉ DE L'INVENTION

A cet effet, l'invention a pour objet un procédé du type précité, comme défini par la revendication 1.

En effet, un tel procédé conduit à la réalisation d'une bobine formant un capteur Rogowski. Un tel capteur présente une bande passante satisfaisante.

En outre, un tel capteur Rogowski ne comporte pas de composants électroniques susceptibles d'être endommagés par une température excessive.

De surcroît, le fonctionnement d'un tel capteur Rogowski repose sur les phénomènes d'induction, de sorte qu'il n'est pas en contact électrique avec les éléments de commutation et est donc moins susceptible de perturber leur fonctionnement que les capteurs de l'état de la technique.

En outre, un tel capteur est destiné à être agencé en périphérie des éléments de commutation, de sorte que son encombrement est moindre.

Suivant d'autres aspects avantageux de l'invention, le procédé comporte une ou plusieurs des caractéristiques suivantes, prise(s) isolément ou suivant toutes les combinaisons techniquement possibles :
- la réalisation des plots est une réalisation par fabrication additive ;
- la réalisation des premiers segments est une réalisation par fabrication additive concomitante à la réalisation des plots ;
- l'au moins un composant électronique est un élément de commutation à semi-conducteur ;
- l'élément de commutation est un transistor à effet de champ, la première borne étant un drain du transistor à effet de champ, la deuxième borne étant une source du transistor à effet de champ, ou un transistor bipolaire, la première borne étant un émetteur du transistor bipolaire, la deuxième borne étant un collecteur du transistor bipolaire.

En outre, l'invention a pour objet un dispositif de protection de court-circuit, comme défini par la revendication 6.

Suivant un aspect avantageux de l'invention, le dispositif de protection de court-circuit comporte, en outre, un organe de commande connecté en sortie du capteur de courant et configuré pour analyser le signal délivré par le capteur de courant.

L'invention a également pour objet un module de puissance comprenant un dispositif de protection de court-circuit tel que défini par la revendication 9.

### BRÈVE DESCRIPTION DES DESSINS

L'invention sera mieux comprise à l'aide de la description qui va suivre, donnée uniquement à titre d'exemple non limitatif et faite en se référant aux dessins annexés sur lesquels :
[Fig. 1] la figure 1 est une représentation schématique en section d'un module de puissance intégrant un dispositif de protection de court-circuit selon l'invention, dans un plan orthogonal à des substrats dudit module de puissance ; et
[Fig. 2] la figure 2 est une représentation schématique en perspective d'une bobine du dispositif de protection intégré au module de puissance de la figure 1.

### EXPOSÉ DÉTAILLÉ DE MODES DE RÉALISATION PARTICULIERS

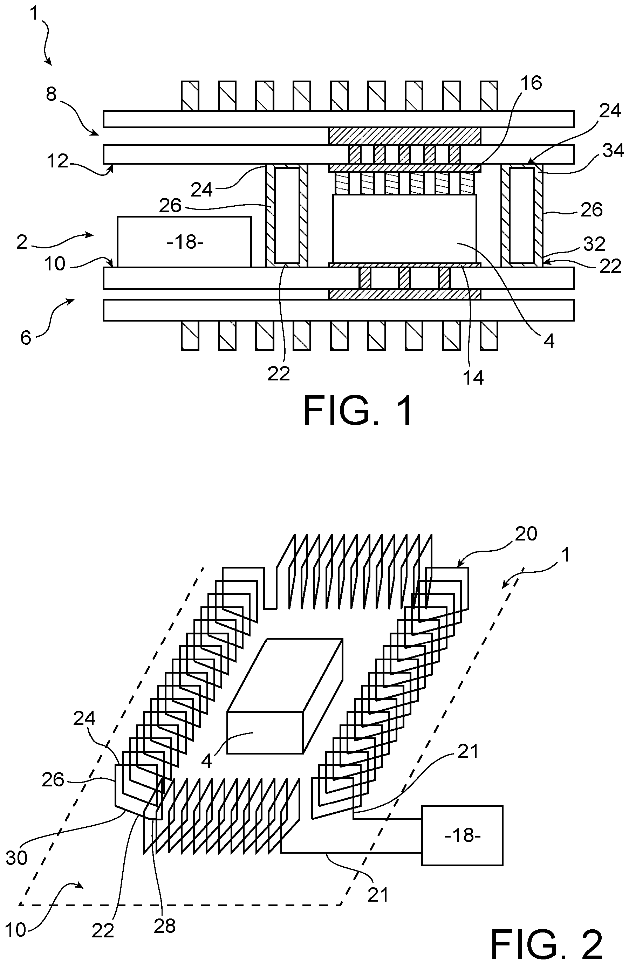

Un dispositif de protection 2 pour la détection de court-circuit susceptible d'affecter au moins un composant électronique 4 est illustré par la figure 1.

Le composant électronique 4 est, notamment, un élément de commutation à semi-conducteur à grand gap, connu de l'homme du métier. Par exemple, le composant électronique 4 est un transistor MOSFET SiC (de l'anglais « *Silicon Carbide Métal Oxide Semiconductor Field Effect* », ou transistor à effet de champ à structure métal-oxyde-semiconducteur au carbure de silicium). En variante, le composant électronique 4 est un élément de commutation en nitrure de gallium (GaN), ou encore un élément de commutation en silicium.

Le dispositif de protection 2 est intégré dans un module de puissance 1.

Par « module de puissance », il est entendu, au sens de la présente invention, un module électronique présentant un refroidissement sur deux de ses faces, comprenant un bras de commutation (dont des transistors de puissance), un organe de commande correspondant et un dispositif de protection.

Le module de puissance 1 comporte un premier substrat 6 et un deuxième substrat 8 s'étendant chacun dans un plan orthogonal au plan de la figure 1. Le premier substrat 6 et le deuxième substrat 8 comprennent respectivement une première face 10 et une deuxième face 12, le premier substrat 6 et le deuxième substrat 8 étant agencés de sorte que la première face 10 et la deuxième face 12 soient en regard et à distance l'une de l'autre.

Le premier substrat 6, respectivement le deuxième substrat 8 est, par exemple, un substrat céramique métallisé.

La première face 10 comporte une première surface de connexion 14. En outre, la deuxième face 12 comporte une deuxième surface de connexion 16. La première surface de connexion 14 et la deuxième surface de connexion 16 sont agencées en regard l'une de l'autre.

Chacune de la première surface de connexion 14 et de la deuxième surface de connexion 16 est électriquement conductrice, et est destinée à être électriquement connectée à une borne respective d'au moins un composant électronique 4 logé entre la première surface de connexion 14 et la deuxième surface de connexion 16, comme cela apparaît sur la figure 1.

Par exemple, dans le cas où le composant électronique 4 est un transistor à effet de champ, le drain du transistor à effet de champ est électriquement relié à l'une parmi la première surface de connexion 14 et la deuxième surface de connexion 16, et la source du transistor à effet de champ est reliée à l'autre parmi la première surface de connexion 14 et de la deuxième surface de connexion 16.

Selon un autre exemple, dans le cas où le composant électronique 4 est un transistor bipolaire, l'émetteur du transistor bipolaire est électriquement relié à l'une parmi la première surface de connexion 14 et la deuxième surface de connexion 16, et le collecteur du transistor bipolaire est reliée à l'autre parmi la première surface de connexion 14 et de la deuxième surface de connexion 16.

Le dispositif de protection 2 comporte un capteur de courant 20 et un organe de commande 18 connecté en sortie du capteur de courant 20.

Le capteur de courant 20 est configuré pour délivrer, au niveau de ses deux sorties 21, un signal représentatif des variations du courant électrique traversant le ou chaque composant électronique 4. Plus précisément, la bobine formant le capteur de courant 20 est telle qu'une variation du courant circulant entre la première surface de connexion 14 et la deuxième surface de connexion 16 entraîne, par induction, l'apparition d'une tension entre les deux sorties 21, dont la valeur est représentative des variations du courant électrique traversant le ou chaque composant électronique 4 connectés entre la première surface de connexion 14 et la deuxième surface de connexion 16.

L'organe de commande 18 est configuré pour analyser le signal délivré par le capteur de courant 20, et pour détecter l'occurrence d'une surintensité affectant le ou chaque composant électronique 4 à partir d'une telle analyse.

En outre, l'organe de commande 18 est configuré pour piloter les composants électroniques 4 (y compris des fonctions spécifiques ayant pour but de fournir et contrôler la charge et/ou la décharge de l'électrode de grille des composants électroniques 4 afin de permettre leurs changements d'état, tels que le passage de l'état ouvert à l'état fermé ou de l'état fermé à l'état ouvert, ainsi que permettre leur maintien dans un état ouvert ou fermé), et pour commander leur ouverture, c'est-à-dire leur passage dans un état bloqué, en cas de détection d'une surintensité.

Comme cela ressort plus clairement de la figure 2, le capteur de courant 20 présente la forme d'une bobine de courant, ceignant au moins partiellement le volume situé entre la première surface de connexion 14 et la deuxième surface de connexion 16. Le capteur de courant 20 est également appelé « enroulement de Rogowski ».

En référence à la figure 1, le capteur de courant 20 comporte une pluralité de premiers segments 22 électriquement conducteurs, une pluralité de deuxièmes segments 24 électriquement conducteurs et une pluralité de plots 26 électriquement conducteurs.

Les premiers segments 22 et/ou les deuxièmes segments 24 et/ou les plots 26 sont, par exemple, réalisés en aluminium, en cuivre, ou encore en alliage comprenant l'un ou l'autre de ces métaux (par exemple un alliage aluminium silicium magnésium AISiMg).

Les premiers segments 22 prennent la forme de pistes électriquement conductrices réalisées sur la première face 10 du premier substrat 6. Chaque premier segment 22 comprend une première extrémité 28 et une deuxième extrémité 30 opposée.

Plus précisément, chaque premier segment 22 est agencé en périphérie de la première surface de connexion 14 de la première face 10, sa première extrémité 28 étant plus proche de la première surface de connexion 14 que sa deuxième extrémité 30.

Chaque premier segment 22 est associé à un rang correspondant, le premier segment 22 associé à un rang quelconque étant agencé entre le premier segment 22 de rang immédiatement inférieur et le premier segment 22 de rang immédiatement supérieur.

Au sens de la présente invention, un premier segment 22 est dit « entre deux autres premiers segments » lorsque, dans un système polaire de coordonnées ayant comme origine un point quelconque de la première surface de connexion 14 et comme axes deux axes orthogonaux quelconques de la première face 10 sécants audit point origine, la première extrémité 28 dudit premier segment 22 présente une coordonnée polaire (c'est-à-dire un angle polaire, encore appelé azimut) comprise entre la coordonnée polaire de la première extrémité 28 de l'un parmi lesdits deux autres premiers segments, et la coordonnée polaire de la première extrémité 28 de l'autre parmi lesdits deux autres premiers segments.

Les deuxièmes segments 24 prennent la forme de pistes électriquement conductrices réalisées sur la deuxième face 12 du deuxième substrat 8.

Chaque deuxième segment 24 est associé à deux premiers segments 22 de rangs successifs.

Des caractéristiques supplémentaires des deuxièmes segments 24 ressortiront de ce qui suit.

Les plots 26 sont distants les uns des autres. Chaque plot 26 s'étend le long d'un axe orthogonal aux substrats 6, 8.

Chaque plot 26 comporte une embase 32 et une extrémité libre 34 opposée.

Chaque plot 26 est en contact mécanique et électrique, par son embase 32, avec un unique premier segment 22 correspondant, l'extrémité libre 34 étant à distance de la première face 10. De préférence, chaque plot 26 est venu de matière avec le premier segment 22 correspondant.

En outre, chaque plot 26 est en contact mécanique et électrique, par son extrémité libre 34, avec un unique deuxième segment 24 correspondant. De préférence, l'extrémité libre 34 de chaque plot 26 est brasée au deuxième segment 24 correspondant.

Les premiers segments 22, les deuxièmes segments 24 et les plots 26 sont agencés de sorte que chaque premier segment 22 soit en contact mécanique et électrique avec deux plots 26, notamment exactement deux plots 26.

Plus précisément, les premiers segments 22, les deuxièmes segments 24 et les plots 26 sont agencés de sorte que chaque deuxième segment 24 soit en contact mécanique et électrique :
- avec le plot 26 qui est en contact mécanique avec le premier segment 22 de rang inférieur parmi les deux premiers segments 22 de rangs successifs associés audit deuxième segment 24, et qui est le plus proche de la première extrémité 28 du premier segment 22 de rang inférieur ; et
- avec le plot 26 qui est en contact mécanique avec le premier segment 22 de rang supérieur parmi les deux premiers segments 22 de rangs successifs associés audit deuxième segment 24, et qui est le plus proche de la deuxième extrémité 30 du premier segment 22 de rang supérieur.

Il résulte de ce qui précède que les premiers segments 22, les deuxièmes segments 24 et les plots 26 sont agencés de façon à former la bobine constituant le capteur de courant 20.

La fabrication du dispositif de protection 2 selon l'invention va maintenant être décrite.

Sur la première face 10 du premier substrat 6, les premiers segments 22 sont réalisés, par exemple par fabrication additive.

Comme cela a été décrit précédemment, chaque premier segment 22 est agencé en périphérie de la première surface de connexion 14 de la première face 10, sa première extrémité 28 étant plus proche de la première surface de connexion 14 que sa deuxième extrémité 30.

Les premiers segments 22 sont électriquement isolés les uns des autres.

En outre, sur la première face 10 du premier substrat 6, les plots 26 sont réalisés par fabrication additive. De préférence, les plots 26 et les premiers segments 22 sont réalisés conjointement par fabrication additive. Dans ce cas, les plots 26 et les premiers segments 22 sont réalisés dans un même matériau. En outre, dans ce cas, chaque plot 26 et chaque premier segment 22 correspondant sont venus de matière.

En outre, sur la deuxième face 12 du deuxième substrat 8, les deuxièmes segments 24 sont réalisés. Les deuxièmes segments 24 sont électriquement isolés les uns des autres.

Puis, la première face 10 du premier substrat 6 et de la deuxième face 12 du deuxième substrat 8 sont mises en regard l'une de l'autre, pour mettre l'extrémité libre 34 de chaque plot 26 en contact mécanique et électrique avec le deuxième segment 24 correspondant.

Une opération de brasage est ensuite réalisée, pour solidariser l'extrémité libre 34 de chaque plot 26 au deuxième segment 24 correspondant.

Du fait des caractéristiques géométriques précédemment décrites des premiers segments 22, des deuxièmes segments 24 et des plots 26, un tel procédé de fabrication conduit à la réalisation du capteur de courant 20 en forme de bobine électriquement conductrice.

Les bornes 21 du capteur de courant 20 sont également connectées en entrée de l'organe de commande 18.

La méthode de fabrication additive utilisée est, par exemple, la méthode dite SLM (de l'anglais « *Selective Laser Melting* », pour fusion sélective par laser).

Un tel procédé de fabrication est avantageux. En effet, la mise en oeuvre de la fabrication additive pour la réalisation des plots 26 autorise un positionnement précis desdits plots, de sorte que la réponse du capteur de courant 20 est conforme à la réponse attendue. En outre, grâce à un tel procédé, les plots 26 présentent une résistance satisfaisante aux efforts de cisaillement, en particulier une bonne adhésion des plots 26 aux premiers segments 22, ce qui confère une bonne robustesse au capteur de courant 20.

En outre, un tel procédé rend inutile l'ajout de composants discrets, susceptibles de perturber le fonctionnement des composants électroniques 4, pour réaliser la mesure de courant.

En outre, un tel procédé autorise un dimensionnement simple du capteur de courant 20, de façon à ce que ce dernier puisse fonctionner, avec un risque réduit d'endommagement, dans un environnement à haute température.

En outre, un tel procédé autorise de réaliser simplement, et en une seule opération, un capteur de courant 20 autour de chaque composant électronique 4. Ceci autorise, par exemple, une mesure du déséquilibre entre les composants électroniques 4 d'un module de puissance donné (par exemple, des transistors en parallèle d'un module de puissance), dans le but de commander lesdits composants pour réduire un tel déséquilibre et prolonger la durée de vie du module de puissance.

En outre, la réalisation conjointe des premiers segments 22 et les plots 26 simplifie ladite réalisation et lui confère une plus grande répétabilité.

En variante, le procédé de fabrication comporte aussi la réalisation de plots 26 sur les deuxièmes segments 24. Ce qui a été décrit précédemment, notamment en ce qui concerne la mise en regard des substrats 6, 8 s'applique encore, les deuxièmes segments 24 portant un plot 26 jouant le rôle des premiers segments 22 précédemment décrits, et les premiers segments 22 destinés à recevoir l'extrémité libre desdits plots 26 jouant, dans ce cas, le rôle des deuxièmes segments 24 précédemment décrits.

## Revendications

1. Procédé de fabrication d'un dispositif (2) de protection de court-circuit pour composant électronique, comportant :
- la réalisation, sur une première face (10) d'un premier substrat (6), d'une pluralité de premiers segments (22) électriquement conducteurs, chaque premier segment (22) étant agencé en périphérie d'une première surface de connexion (14) de la première face (10), chaque premier segment (22) comprenant une première extrémité (28) et une deuxième extrémité (30) opposée, la première extrémité (28) étant plus proche de la première surface de connexion (14) que la deuxième extrémité (30), les premiers segments (22) étant électriquement isolés les uns des autres, chaque premier segment (22) étant associé à un rang correspondant, le premier segment (22) associé à un rang donné quelconque étant agencé entre le premier segment (22) de rang immédiatement inférieur et le premier segment (22) de rang immédiatement supérieur ;
- la réalisation, sur la première face (10) du premier substrat (6), d'une pluralité de plots (26) électriquement conducteurs, distants les uns des autres, chaque plot (26) comportant une embase (32) et une extrémité libre (34) opposée, chaque plot (26) étant en contact mécanique et électrique, par son embase (32), avec un unique premier segment (22) correspondant, l'extrémité libre (34) étant à distance de la première face (10) ;
- la réalisation, sur une deuxième face (12) d'un deuxième substrat (8), d'une pluralité de deuxièmes segments (24) électriquement conducteurs, électriquement isolés les uns des autres, chaque deuxième segment (24) étant associé à deux premiers segments (22) de rangs successifs ;
- la mise en regard de la première face (10) du premier substrat (6) et de la deuxième face (12) du deuxième substrat (8), pour mettre l'extrémité libre (34) de chaque plot (26) en contact mécanique et électrique avec un unique deuxième segment (24) correspondant, de sorte que :
• chaque premier segment (22) soit en contact mécanique et électrique avec deux plots (26) parmi la pluralité de plots (26) ;
• chaque deuxième segment (24) soit en contact mécanique et électrique, d'une part, avec le plot (26) qui est en contact mécanique avec le premier segment (22) de rang inférieur parmi les deux premiers segments (22) de rangs successifs associés au deuxième segment (24), et qui est le plus proche de la première extrémité (28) du premier segment (22) de rang inférieur, et, d'autre part, avec le plot (26) qui est en contact mécanique avec le premier segment (22) de rang supérieur parmi les deux premiers segments (22) de rangs successifs associés audit deuxième segment (24), et qui est le plus proche de la deuxième extrémité (30) du premier segment (22) de rang supérieur;
les premiers segments (22), les deuxièmes segments (24) et les plots (26) formant ainsi une bobine,
le procédé comprenant en outre l'agencement d'au moins un composant électronique (4) entre la première surface de connexion (14) et une deuxième surface de connexion (16) de la deuxième face (12), située en regard de la première surface de connexion (14), une première borne du composant électronique (4) étant connectée électriquement à l'une parmi la première surface de connexion (14) et la deuxième surface de connexion (16), une deuxième borne du composant électronique (4) étant connectée électriquement à l'autre parmi la première surface de connexion (14) et la deuxième surface de connexion (16),
ladite bobine ceignant le volume autour du composant électronique et situé entre la première surface de connexion (14) et la deuxième surface de connexion (16).

2. Procédé de fabrication selon la revendication 1, dans lequel la réalisation des plots (26) est une réalisation par fabrication additive.

3. Procédé de fabrication selon la revendication 2, dans lequel la réalisation des premiers segments (22) est une réalisation par fabrication additive concomitante à la réalisation des plots (26).

4. Procédé de fabrication selon l'une des revendications 1 à 3, dans lequel l'au moins un composant électronique (4) est un élément de commutation à semi-conducteur, en particulier un élément de commutation à semi-conducteur à grand gap.

5. Procédé de fabrication selon la revendication 4, dans lequel l'élément de commutation est un transistor à effet de champ, la première borne étant un drain du transistor à effet de champ, la deuxième borne étant une source du transistor à effet de champ, ou un transistor bipolaire, la première borne étant un émetteur du transistor bipolaire, la deuxième borne étant un collecteur du transistor bipolaire.

6. Dispositif (2) de protection de court-circuit pour composant électronique, comportant :
- un premier substrat (6) comprenant une première face (10) portant une pluralité de premiers segments (22) électriquement conducteurs, chaque premier segment (22) étant agencé en périphérie d'une première surface de connexion (14) de la première face (10), chaque premier segment (22) comprenant une première extrémité (28) et une deuxième extrémité (30) opposée, la première extrémité (28) étant plus proche de la première surface de connexion (14) que la deuxième extrémité (30), les premiers segments (22) n'étant pas directement en contact électrique et mécanique les uns avec les autres, chaque premier segment (22) étant associé à un rang correspondant, le premier segment (22) associé à un rang donné quelconque étant agencé entre le premier segment (22) de rang immédiatement inférieur et le premier segment (22) de rang immédiatement supérieur;
- un deuxième substrat (8) comportant une deuxième face (12) en regard de la première face (10) du premier substrat (6), la deuxième face (12) portant une pluralité de deuxièmes segments (24) électriquement conducteurs, chaque deuxième segment (24) étant agencé en périphérie d'une deuxième surface de connexion (16) de la deuxième face (12) située en regard de la première surface de connexion (14), les deuxièmes segments (24) n'étant pas directement en contact électrique et mécanique les uns avec les autres, chaque deuxième segment (24) étant associé à deux premiers segments (22) de rangs successifs ;
- le composant électronique (4) agencé entre la première face (10) du premier substrat (6) et la deuxième face (12) du deuxième substrat (8), le composant électronique étant doté d'une borne connectée à la première surface de connexion (14) et d'une autre borne connectée à la deuxième surface de connexion (16),
- une pluralité de plots (26) électriquement conducteurs, distants les uns des autres, chaque plot (26) comportant une embase (32) et une extrémité libre (34) opposée, chaque plot (26) étant en contact mécanique et électrique, par son embase (32), avec un unique premier segment (22) correspondant, l'extrémité libre (34) étant à distance de la première face (10) et en contact mécanique et électrique avec un unique deuxième segment (24) correspondant, de sorte que :
• chaque premier segment (22) soit en contact mécanique et électrique avec deux plots (26) parmi la pluralité de plots (26) ;
• chaque deuxième segment (24) soit en contact mécanique et électrique, d'une part, avec le plot (26) qui est en contact mécanique avec le premier segment (22) de rang inférieur parmi les deux premiers segments (22) de rangs successifs associés au deuxième segment (24), et qui est le plus proche de la première extrémité (28) du premier segment (22) de rang inférieur, et, d'autre part, avec le plot (26) qui est en contact mécanique avec le premier segment (22) de rang supérieur parmi les deux premiers segments (22) de rangs successifs associés audit deuxième segment (24), et qui est le plus proche de la deuxième extrémité (30) du premier segment (22) de rang supérieur;
les premiers segments (22), les deuxièmes segments (24) et les plots (26) définissant ainsi une bobine formant un capteur de courant (20) configuré pour délivrer un signal représentatif de variations de courant électrique circulant entre la première surface de connexion (14) et la deuxième surface de connexion (16), ladite bobine ceignant le volume situé entre la première surface de connexion et la deuxième surface de connexion.

7. Dispositif (2) de protection de court-circuit selon la revendication 6, comportant, en outre, un organe de commande (18) connecté en sortie du capteur de courant (20) et configuré pour analyser le signal délivré par le capteur de courant (20).

8. Dispositif (2) de protection de court-circuit selon l'une des revendications 6 ou 7, dans lequel le composant électronique (4) est un élément de commutation à semi-conducteur en particulier un élément de commutation à semi-conducteur à grand gap.

9. Module de puissance (1) comprenant un dispositif (2) de protection de court-circuit selon l'une des revendications 6 à 8, dans lequel le composant électronique (4) est un élément de commutation, l'organe de commande (18) étant configuré pour mettre le composant électronique (4) dans un état bloqué en cas de détection, à partir du signal délivré par le capteur de courant (20), d'une surintensité.

## Patentansprüche

1. Herstellungsverfahren einer Kurzschlussschutzvorrichtung (2) für ein elektronisches Bauteil, das Folgendes umfasst:
- Fertigen, auf einer ersten Seite (10) eines ersten Substrats (6), einer Vielzahl von elektrisch leitenden ersten Segmenten (22), wobei jedes erste Segment (22) am Umfang einer ersten Verbindungsfläche (14) der ersten Seite (10) angeordnet ist, wobei jedes erste Segment (22) ein erstes Ende (28) und ein gegenüberliegendes zweites Ende (30) aufweist, wobei das erste Ende (28) näher an der ersten Verbindungsfläche (14) liegt als das zweite Ende (30), wobei die ersten Segmente (22) elektrisch voneinander isoliert sind, wobei jedes erste Segment (22) einem entsprechenden Rang zugeordnet ist, wobei das erste Segment (22), das einem beliebigen gegebenen Rang zugeordnet ist, zwischen dem ersten Segment (22) des nächsthöheren Rangs angeordnet ist;
- Fertigen einer Vielzahl von voneinander beabstandeten, elektrisch leitfähigen Kontakten (26) auf der ersten Seite (10) des ersten Substrats (6), wobei jeder Kontaktpunkt (26) eine Basis (32) und ein gegenüberliegendes freies Ende (34) aufweist, wobei jeder Kontaktpunkt (26) über seine Basis (32) in mechanischem und elektrischem Kontakt mit einem einzigen entsprechenden ersten Segment (22) steht, wobei das freie Ende (34) von der ersten Seite (10) beabstandet ist;
- Fertigen, auf einer zweiten Seite (12) eines zweiten Substrats (8), einer Vielzahl von elektrisch leitenden, elektrisch voneinander isolierten zweiten Segmenten (24), wobei jedes zweite Segment (24) mit zwei ersten Segmenten (22) aufeinanderfolgender Ränge verbunden ist;
- Gegenüberstellen der ersten Seite (10) des ersten Substrats (6) und der zweiten Seite (12) des zweiten Substrats (8), um das freie Ende (34) jedes Kontaktpunkts (26) in mechanischen und elektrischen Kontakt mit einem einzigen entsprechenden zweiten Segment (24) zu bringen, so dass:
- jedes erste Segment (22) in mechanischem und elektrischem Kontakt mit zwei Kontaktpunkten (26) aus der Vielzahl von Kontaktpunkten (26) steht;
- jedes zweite Segment (24) in mechanischem und elektrischem Kontakt steht, einerseits mit dem Kontaktpunkt (26), der in mechanischem Kontakt mit dem ersten Segment (22) mit niedrigerem Rang unter den zwei ersten Segmenten (22) mit aufeinanderfolgenden Rängen steht, die dem zweiten Segment (24) zugeordnet sind, und der dem ersten Ende (28) des ersten Segments (22) mit niedrigerem Rang am nächsten ist, und, andererseits, mit dem Kontaktpunkt (26), der in mechanischem Kontakt mit dem ersten Segment (22) höheren Rangs unter den zwei ersten Segmenten (22) aufeinanderfolgenden Rangs steht, die dem zweiten Segment (24) zugeordnet sind, und der dem zweiten Ende (30) des ersten Segments (22) höheren Rangs am nächsten liegt;
Wobei die ersten Segmente (22), die zweiten Segmente (24) und die Kontaktpunkte (26) somit eine Spule bilden,
wobei das Verfahren darüber hinaus die Anordnung mindestens eines elektronischen Bauteils (4) zwischen der ersten Verbindungsfläche (14) und einer zweiten Verbindungsfläche (16) der zweiten Seite (12) umfasst, die sich gegenüber der ersten Verbindungsfläche (14) befindet, ein erster Anschluss des elektronischen Bauteils (4) elektrisch mit einer von der ersten Verbindungsfläche (14) und der zweiten Verbindungsfläche (16) verbunden ist, wobei ein zweiter Anschluss des elektronischen Bauteils (4) elektrisch mit der anderen von der ersten Verbindungsfläche (14) und der zweiten Verbindungsfläche (16) verbunden ist,
wobei die Spule das Volumen um das elektronische Bauteil herum umschließt und sich zwischen der ersten Verbindungsfläche (14) und der zweiten Verbindungsfläche (16) befindet.

2. Herstellungsverfahren nach Anspruch 1, bei dem die Fertigung der Kontaktpunkte (26) eine Fertigung durch additive Herstellung ist.

3. Herstellungsverfahren nach Anspruch 2, wobei die Fertigung der ersten Segmente (22) eine Fertigung durch additive Herstellung ist, die mit der Fertigung der Kontaktpunkte (26) einhergeht.

4. Herstellungsverfahren nach einem der Ansprüche 1 bis 3, wobei das mindestens eine elektronische Bauteil (4) ein Halbleiterschaltelement ist, insbesondere ein Halbleiterschaltelement mit großem Schaltabstand.

5. Herstellungsverfahren nach Anspruch 4, wobei das Schaltelement ein Feldeffekttransistor ist, wobei der erste Anschluss ein Ablauf des Feldeffekttransistors ist, der zweite Anschluss eine Quelle des Feldeffekttransistors ist, oder ein Bipolartransistor ist, wobei der erste Anschluss ein Emitter des Bipolartransistors ist, der zweite Anschluss ein Kollektor des Bipolartransistors ist.

6. Kurzschlussschutzvorrichtung (2) für ein elektronisches Bauteil, umfassend:
- ein erstes Substrat (6) mit einer ersten Seite (10), die eine Vielzahl von elektrisch leitenden ersten Segmenten (22) trägt, wobei jedes erste Segment (22) am Umfang einer ersten Verbindungsfläche (14) der ersten Seite (10) angeordnet ist, wobei jedes erste Segment (22) ein erstes Ende (28) und ein gegenüberliegendes zweites Ende (30) aufweist, wobei das erste Ende (28) näher an der ersten Verbindungsfläche (14) liegt als das zweite Ende (30), wobei die ersten Segmente (22) nicht direkt in elektrischem und mechanischem Kontakt miteinander stehen, wobei jedes erste Segment (22) einem entsprechenden Rang zugeordnet ist, wobei das erste Segment (22) den nächstniedrigeren Rang und das erste Segment (22) den nächsthöheren Rang aufweist;
- ein zweites Substrat (8) mit einer zweiten Seite (12), die der ersten Seite (10) des ersten Substrats (6) gegenüberliegt, wobei die zweite Seite (12) eine Vielzahl von elektrisch leitenden zweiten Segmenten (24) trägt, jedes zweite Segment (24) am Umfang einer zweiten Verbindungsfläche (16) der zweiten Seite (12) angeordnet ist, die der ersten Verbindungsfläche (14) gegenüberliegt, wobei die zweiten Segmente (24) nicht direkt miteinander in elektrischem und mechanischem Kontakt stehen, wobei jedes zweite Segment (24) mit zwei ersten Segmenten (22) aufeinanderfolgender Ränge verbunden ist;
- das elektronische Bauteil (4), das zwischen der ersten Seite (10) des ersten Substrats (6) und der zweiten Seite (12) des zweiten Substrats (8) angeordnet ist, wobei das elektronische Bauteil mit einem Anschluss, der mit der ersten Verbindungsfläche (14) verbunden ist, und einem weiteren Anschluss, der mit der zweiten Verbindungsfläche (16) verbunden ist, versehen ist,
- eine Vielzahl von voneinander beabstandeten, elektrisch leitenden Kontaktpunkten (26), wobei jeder Kontaktpunkt (26) eine Basis (32) und ein gegenüberliegendes freies Ende (34) aufweist, wobei jeder Kontaktpunkt (26) über seine Basis (32) in mechanischem und elektrischem Kontakt mit einem entsprechenden einzelnen ersten Segment (22) steht, wobei das freie Ende (34) von der ersten Seite (10) beabstandet ist und in mechanischem und elektrischem Kontakt mit einem entsprechenden einzelnen zweiten Segment (24) steht, so dass:
- jedes erste Segment (22) in mechanischem und elektrischem Kontakt mit zwei Kontaktpunkten (26) aus der Vielzahl von Kontaktpunkten (26) steht;
- jedes zweite Segment (24) in mechanischem und elektrischem Kontakt einerseits mit dem Kontaktpunkt (26) steht, der in mechanischem Kontakt mit dem ersten Segment (22) niedrigeren Rangs unter den zwei ersten Segmenten (22) aufeinanderfolgender Ränge steht, die dem zweiten Segment (24) zugeordnet sind, und der dem ersten Ende (28) des ersten Segments (22) niedrigeren Rangs am nächsten liegt, und andererseits mit dem Kontaktpunkt (26), der in mechanischem Kontakt mit dem ersten höherrangigen Segment (22) der beiden ersten Segmente (22) aufeinanderfolgender Ränge steht, die dem zweiten Segment (24) zugeordnet sind, und der dem zweiten Ende (30) des ersten höherrangigen Segments (22) am nächsten liegt;
- die ersten Segmente (22), die zweiten Segmente (24) und die Kontaktpunkte (26) somit eine Spule definieren, die einen Stromsensor (20) bildet, der konfiguriert ist, um ein Signal zu liefern, das für Änderungen des zwischen der ersten Verbindungsfläche (14) und der zweiten Verbindungsfläche (16) fließenden elektrischen Stroms repräsentativ ist, wobei die Spule das zwischen der ersten Verbindungsfläche und der zweiten Verbindungsfläche befindliche Volumen umschließt.

7. Kurzschlussschutzvorrichtung (2) nach Anspruch 6, die darüber hinaus ein Steuerorgan (18) umfasst, das am Ausgang des Stromsensors (20) angeschlossen und so konfiguriert ist, dass es das von dem Stromsensor (20) gelieferte Signal analysiert.

8. Kurzschlussschutzvorrichtung (2) nach einem der Ansprüche 6 oder 7, wobei das elektronische Bauteil (4) ein Halbleiterschaltelement, insbesondere ein Halbleiterschaltelement mit großem Schaltabstand ist.

9. Leistungsmodul (1) mit einer Kurzschlussschutzvorrichtung (2) nach einem der Ansprüche 6 bis 8, wobei das elektronische Bauteil (4) ein Schaltelement ist, wobei das Steuerorgan (18) so konfiguriert ist, dass es das elektronische Bauteil (4) in einen gesperrten Zustand versetzt, wenn anhand des von dem Stromsensor (20) gelieferten Signals ein Überstrom erfasst wird.

## Claims

1. A method for manufacturing a short-circuit protection device (2), including:
- producing, on a first face (10) of a first substrate (6), a plurality of first electrically conductive segments (22), each first segment (22) being arranged on the periphery of a first connection surface (14) of the first face (10), each first segment (22) comprising a first end (28) and an opposite second end (30), the first end (28) being closer to the first connection surface (14) than the second end (30), the first segments (22) being electrically insulated from each other, each first segment (22) being associated with a corresponding rank, the first segment (22) associated with any given rank being arranged between the first segment (22) of immediately lower rank and the first segment (22) of immediately higher rank;
- producing, on the first face (10) of a first substrate (6), a plurality of electrically conductive pads (26), which are distant from each other, each pad (26) including a base (32) and an opposite free end (34), each pad (26) being in mechanical and electrical contact, through the base (32) thereof, with a single corresponding first segment (22), the free end (34) being at a distance from the first face (10);
- producing, on a second face (12) of a second substrate (8), a plurality of second electrically conductive segments (24), which are electrically insulated from each other, each second segment (24) being associated with first two segments (22) of successive ranks;
- placing the first face (10) of the first substrate (6) and the second face (12) of the second substrate (8) opposite to each other, to bring the free end (34) of each pad (26) into mechanical and electrical contact with a single corresponding second segment (24), such that:
• each first segment (22) is in mechanical and electrical contact with two pads (26) of the plurality of pads (26);
• each second segment (24) is in mechanical and electrical contact, on the one hand, with the pad (26) which is in mechanical contact with the first segment (22) of lower rank among the first two segments (22) of successive ranks associated with the second segment (24), and which is closest to the first end (28) of the first segment (22) of lower rank, and on the other hand, with the pad (26) which is in mechanical contact with the first segment (22) of higher rank among the first two segments (22) of successive ranks associated with said second segment (24), and which is closest to the second end (30) of the first segment (22) of higher rank;
the first segments (22), the second segments (24) and the pads (26) thus forming a coil,
the method further comprising the arrangement of at least one electronic component (4) between the first connection surface (14) and a second connection surface (16) of the second face (12), located facing the first connection surface (14), a first terminal of the electronic component (4) being electrically connected to one of the first connection surface and the second connection surface (14), a second terminal of the electronic component (4) being electrically connected to the other of the first connection surface (14) and the second connection surface (16),
said coil enclosing the volume around the electronic component and located between the first connection surface (14) and the second connection surface (16).

2. The manufacturing method according to claim 1, wherein the production of the pads (26) is a production by additive manufacturing.

3. The manufacturing method according to claim 2, wherein the production of the first segments (22) is a production by additive manufacturing concomitant with the production of the pads (26).

4. The manufacturing method according to any of the claims 1 to 3, wherein the at least one electronic component (4) is a semiconductor switching element, in particular a large gap semiconductor switching element.

5. The manufacturing method according to claim 4, wherein the switching element is a field effect transistor, the first terminal being a drain of the field effect transistor, the second terminal being a source of the field effect transistor, or a bipolar transistor, the first terminal being an emitter of the bipolar transistor, the second terminal being a collector of the bipolar transistor.

6. A short-circuit protection device (2), including:
- a first substrate (6) comprising a first face (10) carrying a plurality of first electrically conductive segments (22), each first segment (22) being arranged on the periphery of a first connection surface (14) of the first face (10), each first segment (22) comprising a first end (28) and an opposite second end (30), the first end (28) being closer to the first connection surface (14) than the second end (30), the first segments (22) not being directly in electrical and mechanical contact with each other, each first segment (22) being associated with a corresponding rank, the first segment (22) associated with any given rank being arranged between the first segment (22) of immediately lower rank and the first segment (22) of immediately higher rank;
- a second substrate (8) including a second face (12) facing the first face (10) of the first substrate (6), the second face (12) carrying a plurality of second electrically conductive segments (24), each second segment (24) being arranged on the periphery of a second connection surface (16) of the second face (12) located facing the first connection surface (14), the second segments (24) not being directly in electrical and mechanical contact with each other, each second segment (24) being associated with first two segments (22) of successive ranks;
- a plurality of electrically conductive pads (26), distant from each other, each pad (26) including a base (32) and an opposite free end (34), each pad (26) being in mechanical and electrical contact, by the base (32) thereof, with a single corresponding first segment (22), the free end (34) being at a distance from the first face (10) and in mechanical and electrical contact with a single corresponding second segment (24), such that:
• each first segment (22) is in mechanical and electrical contact with two pads (26) of the plurality of pads (26);
• each second segment (24) is in mechanical and electrical contact, on the one hand, with the pad (26) which is in mechanical contact with the first segment (22) of lower rank among the first two segments (22) of successive ranks associated with the second segment (24), and which is closest to the first end (28) of the first segment (22) of lower rank, and, on the other hand, with the pad (26) which is in mechanical contact with the first segment (22) of higher rank among the first two segments (22) of successive ranks associated with said second segment (24), and which is closest to the second end (30) of the first segment (22) of higher rank;
the first segments (22), the second segments (24) and the pads (26) thus defining a coil forming a current sensor (20) configured to deliver a signal representative of variations in electric current flowing between the first connection surface (14) and the second connection surface (16).

7. The short-circuit protection device (2) according to claim 6, further including a control member (18) connected to the output of the current sensor (20) and configured to analyse the signal delivered by the current sensor (20).

8. The short-circuit protection device (2) according to any of the claims 6 or 7, wherein the electronic component (4) is a semiconductor switching element, in particular a large gap semiconductor switching element.

9. A power module (1) comprising a short-circuit protection device (2) according to any of the claims 6 to 8, wherein the electronic component (4) is a switching element, the control member (18) being configured to put the electronic component in a blocked state in the case of detection, from the signal delivered by the current sensor, of an overcurrent.
